# EUROPEAN PATENT APPLICATION

(11) **EP 4 456 134 A1**
(43) Date of publication of application: **30.10.2024**
(21) Application number: 23216217.2
(22) Date of filing: 13.12.2023
(51) Int. Cl.: H01L 25/075

(54) **PHOTONIC INTEGRATED CIRCUIT PACKAGES WITH SCALABLE HETEROGENEOUS INTEGRATION**

(30) Priority: 24.04.2023 US 202318305525
(71) Applicant: INTEL Corporation, Santa Clara, CA 95054 (US)
(72) Inventor: KLOWDEN, Daniel, Portland, 97212 (US); FRYMAN, Joshua, Corvallis, 97330 (US)
(74) Representative: 2SPL Patentanwälte PartG mbB

(57) **Abstract**

An IC package may include a stack of microelectronic units capable of horizontal and vertical optical communications. A microelectronic unit includes one or more power delivery pillars, two light source layers, an optical interconnect layer between the light source layers, and one or more IC devices arranged on the optical interconnect layer. A light source layer includes micro-LEDs that emit light used for generating optical signals. The optical interconnect layer includes one or more optical interconnects that enable horizontal optical communication, e.g., transmission of optical signals between the IC devices. A light source layer in the microelectronic unit can facilitate optical communications with another microelectronic unit that is below or above the microelectronic unit. A channel may exist above or below the light source layer to promote dissipation of heat generated by the IC devices. Light from the light source layer may pass through the channel for vertical optical communication.

## Description

### Background

A photonic integrated circuit (PIC) is an integrated circuit (IC) that includes both electronic components (such as microelectronic components) and optical components (such as light emitters, optical fabler, waveguide, etc.). The electronic components can form a functional circuit. The optical components can provide optical interconnections for the electronic components. Multiple PICs may be integrated together to form a PIC package through heterogeneous integration. Heterogeneous integration refers to the integration of separately fabricated components (e.g., separate PICs) into a higher-level assembly (e.g., an IC package) that, in the aggregate, provides enhanced functionality and improved operating characteristics. Heterogeneous integration can enable continued increase in functional density and decrease in cost per function required to maintain the progress in cost and performance for electronics.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a perspective view of an example microelectronic unit capable of optical communication, according to some embodiments of the disclosure.
FIG. 2 is a perspective view of an example microelectronic assembly capable of vertical and horizontal optical communications, according to some embodiments of the disclosure.
FIG. 3 is a perspective view of an example microelectronic assembly including multiple sub-assemblies, according to some embodiments of the disclosure.
FIG. 4 is a cross-sectional view of an example microelectronic unit, according to some embodiments of the disclosure.
FIG. 5 is a perspective view of an example microelectronic assembly including microelectronic sub-assemblies stacked vertically and horizontally, according to some embodiments of the disclosure.
FIGS. 6A-6B are top views of a wafer and dies, according to some embodiments of the disclosure.
FIG. 7 is a side, cross-sectional view of an example IC package that may include one or more microelectronic assemblies capable of vertical and horizontal optical communications, according to some embodiments of the disclosure.
FIG. 8 is a cross-sectional side view of an IC device assembly that may include components having one or more microelectronic assemblies capable of vertical and horizontal optical communications, according to some embodiments of the disclosure.
FIG. 9 is a block diagram of an example computing device that may include one or more components with one or more microelectronic assemblies capable of vertical and horizontal optical communications, according to some embodiments of the disclosure.

### Detailed Description

Microelectronic processing ICs in computer systems (e.g., large-scale computer systems) often operate at very high clock speeds in parallel. However, severe bottlenecks of data transmission in the electrical interconnection between ICs or between boards restrict the high-speed processing in the computer systems. Optical interconnection is a solution to overcome this problem. Optical interconnection can enable high-speed parallel data transfer by light, optical clock, data signal distribution, and so on. A PIC can provide optical interconnections for transmitting optical signals between microelectronic components (e.g., transistors, capacitors, resistors, diodes, inductors, etc.). A PIC package including multiple PICs arranged in a heterogenous stack has the advantage of device scaling and cost reduction, compared with packing more electronic components in a monolithic PIC.

However, currently available three-dimensional heterogeneous integration solutions have limits to scalability within stack. Such limits are typically driven by thermo-mechanical limitations as well as the capability to transmit data around multi-ICs. Thermal concerns can limit the number of ICs that can be placed in the stack before internal ICs are unable to diffuse heat. The data movement requirements within the stack can also limit the width and standardization of the silicon in the state.

Currently available solutions to the problem include silicon bridge technologies and vertical stacking technologies. Additional solutions for scalability of heterogenous capabilities include multi-packaged dies using electrical package interconnects. However, these solutions suffer from limited bandwidth and scalability. For instance, there can be limited scalability (e.g., the number of ICs that can be placed in the stack is limited) due to thermal concerns, interconnect limitations, and power delivery issues. There can be additional limitations due to interconnect limitations within an individual IC. Therefore, improved technology for PIC package is needed.

Embodiments of the present disclosure may improve on at least some of the challenges and issues described above by providing PIC packages capable of both vertical and horizontal optical communications. A microelectronic assembly in a PIC package may include a stack of microelectronic units, in which signals from and to electronic components can be propagated optically in both the direction along which the microelectronic units are stacked (i.e., the vertical direction) and in planes substantially perpendicular to the direction (i.e., horizontal direction).

In various embodiments of the present disclosure, a microelectronic unit includes two light source layers, an optical interconnect layer, and one or more electronic components. The optical interconnect layer may be sandwiched between the light source layers. The electronic components may be attached on the optical interconnect layer. A light source layer may include an array of micro light-emitting diodes (micro-LEDs). The optical interconnect layer may include one or more optical interconnects for transmitting optical signals generated based on light from a light source layer. The optical interconnect layer can facilitate optical communications between the electronic components in the microelectronic unit. Such optical communications are referred to as horizontal optical communications. A light source layer in the microelectronic unit can facilitate optical communications with another microelectronic unit that is below or above the microelectronic unit. Such optical communications are referred to as vertical optical communications.

There may be a channel between a light source layer in the microelectronic unit and a light source layer outside the microelectronic unit (e.g., a light source layer in another microelectronic unit or a light source layer for power delivery). The channel can enhance heat dissipation. The channel may be partially or wholly filled with a fluid, such as gas or liquid, that can further promote cooling of the microelectronic units. The channel (or the fluid in the channel) may be substantially transparent so that photons can be transferred between the two light source layers. In some embodiments, the channel may have a height of approximately 3 millimeters (mm).

In addition to the microelectronic units and channel(s), the microelectronic assembly may include one or more pillars. A pillar may have a longitudinal axis substantially perpendicular to the light source layers or the optical interconnect layer. The pillar may cross the microelectronic units in the microelectronic assembly. The pillar can deliver electrical power to the microelectronic units. Additionally or alternatively, the pillar can provide mechanical support to the microelectronic units.

The channel and pillar in the present disclosure can reduce or even eliminate the scalability limitation caused by thermal and mechanical concerns and therefore, can enhance the three-dimensional heterogeneous integration capability of the IC packages. With the better thermo-mechanical capabilities provided by the channel and pillar, an IC package in the present disclosure can have more microelectronic units arranged in a stack, compared with currently available IC packages. Also, as light source layers can facilitate vertical optical communication and optical interconnect layers can facilitate horizontal optical communications, the present disclosure does not have the vertical and horizontal interconnect limitations suffered by the currently available IC package solutions. Thus, the present disclosure provides more advantageous technologies for IC package.

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in a way that limits the broad scope of the present disclosure and its potential applications.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are stated in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "IC" means a circuit that is integrated into a monolithic semiconductor or analogous material.

In some embodiments, the IC dies disclosed herein may comprise substantially monocrystalline semiconductors, such as silicon or germanium, as a base material on which integrated circuits are fabricated with traditional semiconductor processing methods. The semiconductor base material may include, for example, N-type or P-type materials. Dies may include, for example, a crystalline base material formed using a bulk silicon (or other bulk semiconductor material) or a semiconductor-on-insulator (SOI, e.g., a silicon-on-insulator) structure. In some other embodiments, the base material of one or more of the IC dies may comprise alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may comprise compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may comprise an intrinsic IV or III-V semiconductor material or alloy, not intentionally doped with any electrically active impurity; in alternate embodiments, nominal impurity dopant levels may be present. In still other embodiments, dies may comprise a non-crystalline material, such as polymers; for example, the base material may comprise silica-filled epoxy. In other embodiments, the base material may comprise high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of input/output (I/O) functions, arithmetic operations, pipelining of data, etc.).

In another example, the terms "package" and "IC package" are synonymous, as are the terms "die" and "IC die." Note that the terms "chip," "chiplet," "die," and "IC die" are used interchangeably herein.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., metal oxide semiconductor (MOS) FETs (MOSFETs). In general, a FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PCI. In such cases, the term "interconnect" may refer to optical waveguides (e.g., structures that guide and confine light waves), including optical fiber, optical splitters, optical combiners, optical couplers, and optical vias.

The term "conductive trace" may be used to describe an electrically conductive element isolated by an insulating material. Within IC dies, such insulating material comprises interlayer low-k dielectric that is provided within the IC die. Within package substrates, and printed circuit boards (PCBs) such insulating material comprises organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A or B" or the phrase "A and/or B" means (A), (B), or (A and B). For the purposes of the present disclosure, the phrase "A, B, or C" or the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

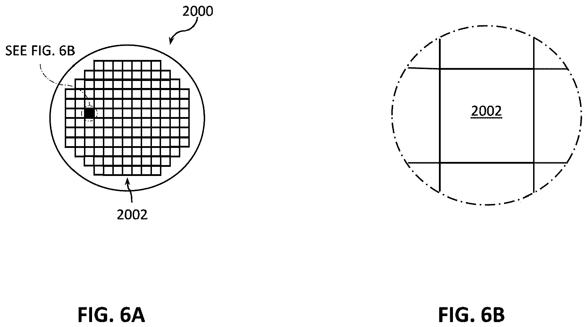

For convenience, if a collection of drawings designated with different letters are present (e.g., FIGS. 6A-6B), such a collection may be referred to herein without the letters (e.g., as "FIG. 6"). Similarly, if a collection of reference numerals designated with different letters are present (e.g., 110A, 110B, 110C), such a collection may be referred to herein without the numbers (e.g., as "110").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

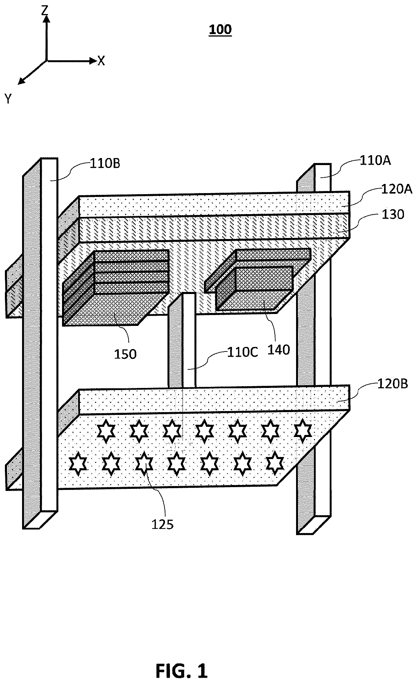

FIG. 1 is a perspective view of an example microelectronic unit 100 capable of optical communication, according to some embodiments of the disclosure. The microelectronic unit 100 may be part of a PIC package. The microelectronic unit 100 includes pillars 110A-110C (collectively referred to as "pillars 110" or "pillar 110"), light source layers 120A and 120B (collectively referred to as "light source layers 120" or "light source layer 120"), an optical interconnect layer 130, and IC devices 140 and 150. In other embodiments, the microelectronic unit 100 may include fewer, more, or different components. For instance, the microelectronic unit 100 may include a different number of pillar(s) 110, a different number of light source layer(s) 120, multiple optical interconnect layers 130, or a different number of IC devices. Also, the arrangement of the IC devices 140 and 150 may be different.

A pillar 110 may supply electrical power to other components of the microelectronic unit 100, such as the light source layers 120. A pillar 110 may be an electrically conductive structure. In some embodiments (e.g., embodiment where a pillar 110 is not be used for electrical signaling), the pillar 110 may include one or more materials with high electrical conductivity or low impedance. Examples of the materials may include Ni (Nickel), Cu (Copper), Au (Gold), Pd (Palladium), other types of electrically conductive materials, or some combination thereof. A pillar 110 has a longitudinal axis along the Z axis and a transvers cross-section perpendicular to the longitudinal axis. In some embodiments, a dimension of the pillar 110 along the longitudinal axis may be greater than dimensions along other directions, e.g., directions along the X and Y axes. The pillars 110 may be in parallel with each other. The pillars 110 may define a frame within which the light source layers 120, optical interconnect layer 130, and IC devices 140 and 150 can be arranged. A pillar 110 may also provide mechanical support to other components of the microelectronic unit 100, such as the light source layers 120 or the optical interconnect layer 130. A pillar 110 may be made of materials of high mechanical strength.

The light source layers 120 provides light, e.g., based on power supplied by one or more of the pillars 110. Each light source layer 120 includes a plurality of light emitters 125 (individually referred to as "light emitter 125"). Each light emitter 125 can emit light. In some embodiments, a light emitter 125 is a LED, e.g., micro-LED, also referred to as a microLED, mLED, or µLED. The size of a light emitter 125 may be smaller than approximately 100 micrometers (µm). In some embodiments, the size of a light emitter 125 may be approximately 1 µm.

In some embodiments, a light emitter 125 emits light of a single color or a single wavelength. In other embodiments, a light emitter 125 may emit light of multiple colors or multiple wavelengths. The light emitters 125 in a light source layer 120 may be arranged in rows, or columns and rows. Each In an embodiment, the light emitters 125 in the light source layers 120 may emit light of the same color. In another embodiment, the light emitters 125 in the light source layer 120A may emit light of a different color from the light emitters 125 in the light source layer 120B. In yet another embodiment, the light emitters 125 in the same light source layer 120 may emit light of different colors. Even though the light emitters 125 are described in various embodiments, a light source layer 120 may include one or more different types of light emitters in addition or alternative to the light emitters 125.

The light source layer 120 may include a support structure (e.g., a substrate, wafer, etc.) based on which the light emitters 125 are arranged. The support structure may include an optical medium (e.g., silicon, etc.) that can facilitate transmission of optical signals. Also, the support structure may include or otherwise be associated with one or more optical lenses that can converge or diverge light emitted from the light emitters 125.

Each light source layer 120 has a top surface and a bottom surface. The two surfaces oppose each other. In some embodiments, the light emitters 125 in a light source layer 120 may be arranged on one of the two surfaces of the light source layer 120. For example, the light emitters 125 in the light source layer 120A may be arranged on the top surface of the light source layer 120A. These light emitters 125 can facilitate optical communication with another light source layer (not shown in FIG. 1) that is above the light source layer 120A. As another example, the light emitters 125 in the light source layer 120B may be arranged on the bottom surface of the light source layer 120B. These light emitters 125 can facilitate optical communication with another light source layer (not shown in FIG. 1) that is below the light source layer 120B. The light source layers 120 can facilitate vertical optical communication in the microelectronic unit 100, i.e., optical communication in directions along the Z axis.

Each light source layer 120 and the optical interconnect layer 130 may have a longitudinal axis in the X-Y plane. The dimension of a light source layer 120 or the optical interconnect layer 130 along the X or Y axis may be greater than its dimension along the Z axis. In some embodiments, the longitudinal axis of a pillar 110 is substantially perpendicular to each light source layer 120 and the optical interconnect layer 130. The light source layers 120 may be substantially parallel to each other and to the optical interconnect layer 130. The optical interconnect layer 130 is between the two light source layers 120. A light source layer 120 may also be referred to as a light source plane. The optical interconnect layer 130 may also be referred to as an optical interconnect plane.

The optical interconnect layer 130 can facilitate horizontal optical communication in the microelectronic unit 100, such as optical communication in the X-Y plane. For instance, the optical interconnect layer 130 provides horizontal connectivity between the IC devices 140 and 150. The horizontal connectivity may be all-to-all connectivity, with which the IC devices 140 and 150 can communicate with each other. The optical interconnect layer 130 may include one or more silicon photonics structures. In some embodiments, the optical interconnect layer 130 includes one or more optical interconnects. An optical interconnect can provide optical connectivity between two or more components of the microelectronic unit 100 and facilitate communication of optical signals between these components. An optical interconnect may be an optical channel, such as optical fiber (e.g., glass fiber), optical waveguide, etc.

In some embodiments, an optical interconnect may receive an optical signal, which may be generated based on light emitted from a light source layer 120. The optical interconnect can transmit the optical signal to the IC device 140 or 150. The optical interconnect may include silicon, silicon nitride, or other materials that can enable high bandwidth. Even though not shown in FIG. 1, the optical interconnect layer 130 may include a modulator that can modulate the light emitted from the light source layer 120 and output modulated optical signals to be received by the optical interconnect. The modulated optical signals may be used as clock signals for the IC device 140 or 150. Also, the optical interconnect layer 130 may also include a support structure, such as a wafer or substrate. An optical interconnect may be embedded inside or on the support structure. An optical interconnect may extend along the support structure.

The IC devices 140 and 150 receive optical signals from the optical interconnect layer 130. The IC devices 140 and 150 may convert the optical signals into electrical signals and function based on the electrical signals. The IC device 140 or 150 may be a computer system or part of a computer system, such as memory, processor, and so on. The IC device 140 or 150 may include one or more transistors, capacitors, diodes, transistors, diodes, power sources, resistors, capacitors, inductors, sensors, transceivers, receivers, antennas, other types of electronic components, or some combination thereof.

For the purpose of illustration, the IC device 140 includes four structures stacked together, and the IC device 150 includes two structures stacked together. In other embodiments, the IC device 140 or 150 may include a different number of structure(s). A structure in the IC device 140 or 150 may be a wafer or a die. In some embodiments, the structures in the IC device 140 or 150 may be assembled by using copper-to-copper (CtC) attachment. For instance, discrete singulated dies may be pre-thinned to expose the copper layer and then be attached together to deliver a heterogenous stack of semiconductor (e.g., silicon).

The IC devices 140 and 150 are attached to the optical interconnect layer 130. In some embodiments, the optical interconnect layer 130 may be wafer-scale assembled and the IC device 140 or 150 may be attached onto the IC devices 140 and 150 through µbump, Copper-to-Wafer (CtW) attachment, or other techniques. The connectivity pitch may be up to 1 µm . In some embodiments, the IC devices 140 and 150 may be tested (e.g., independently tested) before they are attached to the optical interconnect layer 130. Even though the IC devices 140 and 150 do not touch the light source layer 120B in FIG. 1, the light source layer 120B may be attached to the IC device 140 or 150 in other embodiments. For instance, the light source layer 120B may be attached to the IC device 140 or 150 through CtW attachment (e.g., with substrate thinning to allow for die-sided copper attached), CtC attachment, or other types of attachment.

Even though not shown in FIG. 1, there may be one or more other layers between the light source layer 120A and the optical interconnect layer 130. For instance, there may be a substrate (e.g., a glass substrate) between the light source layer 120A and the optical interconnect layer 130. The substrate may provide mechanical support to the light source layer 120A or the optical interconnect layer 130. Alternatively or additionally, there may be a power plane (e.g., a PMIC (power management integrated circuit) power plane) between the light source layer 120A and the optical interconnect layer 130. The optical interconnect layer 130 may be Wafter-to-Wafter (WtW) attached to the light source layer 120A or another plane between the light source layer 120A and the optical interconnect layer 130. In some embodiments, before the attachment, one or more coupling elements may be formed in a light source layer 120 or the optical interconnect layer 130 for attaching the layer to one or more of the pillars 110. The one or more coupling elements may include notch, grove, adhesive element (e.g., glue, etc.), other types of coupling elements, or some combination thereof.

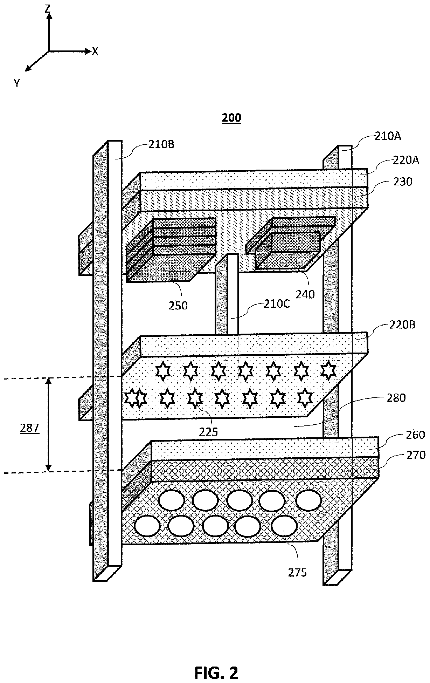

The microelectronic unit 100 may be part of a microelectronic assembly, which may include one or more other microelectronic units or one or more other types of components. The microelectronic unit 100 may be referred to as a microelectronic sub-assembly in the microelectronic assembly. Such a microelectronic assembly may be formed through scalable heterogeneous integration, which may include stacking one or more microelectronic units and optically, one or more other components. More details regarding stacking of microelectronic units and scalable heterogeneous integration are provided below in conjunction with FIGS. 2, 3, and 5.

FIG. 2 is a perspective view of an example microelectronic assembly 200 capable of vertical and horizontal optical communications, according to some embodiments of the disclosure. The microelectronic assembly 200 may be a PIC package or part of a PIC package. The microelectronic assembly 200 includes pillars 210A-110C (collectively referred to as "pillars 210" or "pillar 210"), light source layers 220A and 220B (collectively referred to as "light source layers 220" or "light source layer 220"), an optical interconnect layer 230, IC devices 240 and 250, another light source layer 260, and a power delivery layer 270. In other embodiments, the microelectronic assembly 200 may include fewer, more, or different components. The light source layers 220, optical interconnect layer 230, and IC devices 240 and 250, together with at least part of each pillar 210, may constitute a microelectronic unit, an embodiment of which is the microelectronic unit 100 in FIG. 1. An embodiment of each pillar 210 may be a pillar 110 in FIG. 1. Each light source layer 220 includes an array of light emitters 225. An embodiment of each light source layer 220 may be a light source layer 120. An embodiment of each light emitter 225 may be a light emitter 125. An embodiment of the optical interconnect layer 230 may be the optical interconnect layer 130. An embodiment of the IC device 240 or 250 may be the IC device 140 or 150.

The light source layer 260 includes a plurality of light emitters (not shown in FIG. 2). The light emitters may be micro-LEDs. In some embodiments, the light source layer 260 may have the same or similar structure or components as a light source layer 220. As shown in FIG. 1, the light source layer 260 is below the light source layer 220B. There is a channel 280 between the light source layer 220B and the light source layer 260. The channel 280 may be a gap. In some embodiments, the channel may be partially or wholly filled with one or more fluids. A fluid in the channel 280 may be a cooling agent that can help dissipate heat away from the light source layer 220B. The heat may be generated from the operation of the IC device 240 or 250. In some embodiments, the fluid may flow through the channel 280 or part of the channel 280 to enhance the cooling effect. The channel 280 has a height 287, which is a dimension along the Z axis. In some embodiments, the height 287 may be in the range of the minimum distance to support an effective thermal control gap to the maximum distance to support a free-space optical channel. In other embodiments, the height 287 may be determined based on one or more other factors. In some embodiments, the height 287 is or is approximately 3 mm.

The channel 280 (or fluid(s) in the channel 280) is substantially transparent so that light from the light source layer 260 can pass through the channel 280 and reach the light source layer 220B, or vice versa. In some embodiments, one or more optical lenses may be arranged in or otherwise associated with the channel 280. An optical lens may be formed based on a fluid in the channel 280. In some embodiments, the channel 280 includes a solid structure that is substantially transparent to light from the light source layer 260. The solid structure may be formed with one or more fluid cooling channels for dissipating heat.

The one or more optical lenses can converge or diverge light the light source layer 220 or 260. Each light source layer 220 or the light source layer 260 may include a an optical medium (e.g., silicon) through which light can pass. The light source layers 220 and 260 (together with the channel 280) can therefore facilitate optical communications in directions along the Z axis, i.e., vertical optical communications. As described above, the optical interconnect layer 230 can enable optical communications in the X-Y plane, i.e., horizontal optical communications. Hence, the microelectronic assembly 200 is capable of both vertical and horizontal optical communications.

The power delivery layer 270 may provide electrical power to the light source layer 260 or one or more other components of the microelectronic assembly 200. The power delivery layer 270 includes a plurality of bumps 275 (individually referred to as "bump 275"). A bump 275 may be a micro-bump. In some embodiments, a pitch of the bumps 275 may be approximately 1 µm . Each bump 275 may include an electrically conductive material. The electrically conductive material may include metal, such as Ni, Cu, Au, Pd, other metals, or some combination thereof. Each bump 275 may be electrically coupled to a terminal of a light emitter in the light source layer 260 for delivering power to the light emitter.

The power delivery layer 270 may contact the light source layer 260. In some embodiments, the light source layer 260 may be WtW attached to the power delivery layer 270, or vice versa. In some embodiments, the power delivery layer 270 may also provide mechanical support to the microelectronic assembly 200. In some embodiments, the power delivery layer 270 may be electrically coupled to one or more of the pillars 210. In other embodiment, the power delivery layer 270 may be electrically insulated from one or more of the pillars 210. In some embodiments, one or more coupling elements may be formed in the light source layer 260 or the power delivery layer 270 for attaching the layer to one or more of the pillars 110. The one or more coupling elements may include notch, grove, adhesive element (e.g., glue, etc.), other types of coupling elements, or some combination thereof.

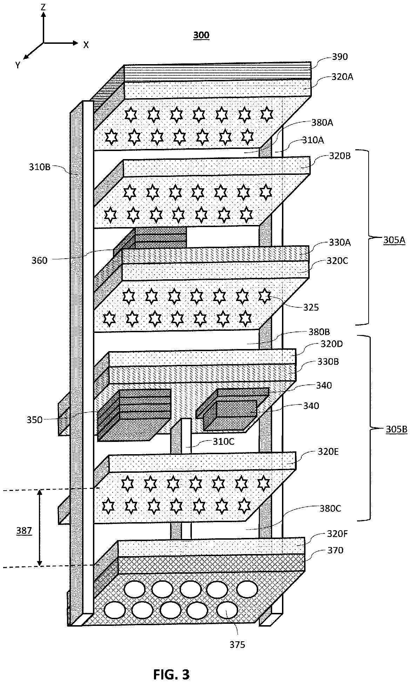

FIG. 3 is a perspective view of an example microelectronic assembly 300 including multiple microelectronic units 305A and 305B, according to some embodiments of the disclosure. The microelectronic assembly 300 may be a PIC package or part of a PIC package. As shown in FIG. 3, the microelectronic assembly 300 includes pillars 310A-110C (collectively referred to as "pillars 310" or "pillar 310"), light source layers 320A-320F (collectively referred to as "light source layers 320" or "light source layer 320"), optical interconnect layers 330A and 330B (collectively referred to as "optical interconnect layers 330" or "optical interconnect layer 330"), IC devices 340, 350, and 360, a power delivery layer 370, and a radio frequency (RF) layer. In other embodiments, the microelectronic assembly 300 may include fewer, more, or different components.

A pillar 310 extends along the Z axis. A pillar 310 (e.g., the pillar 310A or 310B) crosses the light source layers 320, optical interconnect layers 330, the power delivery layer 370, and the RF layer 390. In some embodiments, a pillar 310 may deliver electrical power to one or more of the light source layers 320, optical interconnect layers 330, the power delivery layer 370, and the RF layer 390. The pillars 310 can also provide mechanical support to at least some of the light source layers 320, the optical interconnect layers 330, the power delivery layer 370, and the RF layer 390. An embodiment of each pillar 310 may be a pillar 110 in FIG. 1. In some embodiments, one or more coupling elements (e.g., notch, grove, etc.) may be formed in a light source layer 320, an optical interconnect layer 330, the power delivery layer 370, or the RF layer 390. The coupling element(s) can be used to affix the light source layer 320, the optical interconnect layer 330, the power delivery layer 370, or the RF layer 390 to one or more of the pillars 310.

Each light source layer 320 includes an array of light emitters 325. An embodiment of each light source layer 320 may be a light source layer 120. An embodiment of the light source layer 320F may be the light source layer 260 in FIG. 2. An embodiment of each light emitter 325 may be a light emitter 125 in FIG. 1. An embodiment of each optical interconnect layer 330 may be the optical interconnect layer 130. An embodiment of the IC device 340, 350, or 360 may be the IC device 140 or 150. The power delivery layer 370 includes a plurality of bumps 375 (individually referred to as "bump 375"). An embodiment of the power delivery layer 370 may be the power delivery layer 270 in FIG. 2. An embodiment of each bump 375 may be a bump 275. The RF layer 390 may facilitate communication of the microelectronic assembly 300 with one or more other microelectronic assemblies, IC packages, or other types of systems. The RF layer 390 may includes one or more components that can generate, transmit, or receive RF signals, such as signals with frequencies in a range from 3 kHz to 300 GHz.

The light source layers 320B and 320C, the optical interconnect layer 330A, and the IC device 360, together with at least part of each pillar 310, may constitute the microelectronic unit 305A. The light source layers 320D and 320E, the optical interconnect layer 330B, and the IC devices 340 and 350, together with at least part of each pillar 310, may constitute the microelectronic unit 305B. In other embodiments, the microelectronic unit 305A or 305B may include different, fewer, or more components. For instance, the microelectronic unit 305A or 305B may include different, fewer, or more IC device(s). Also, the components in the microelectronic unit 305A or 305B may be arranged in a different way from the arrangement shown in FIG. 3. For instance, the IC device 340 or 350 may contact the light source layer 320E. Similarly, the IC device 360 may contact the light source layer 320B. The microelectronic unit 305A or 305B may also be referred to as microelectronic sub-assemblies.

The microelectronic units 305A and 305B are associated with channels 380A-380C (collectively referred to as "channels 380" or "channel 380"). Each channel 380 is between two light source layers 320. The channel 380A is between the light source layers 320A and 320B and is above the microelectronic unit 305A. The channel 380B is between the light source layers 320C and 320D and is between the microelectronic unit 305A and the microelectronic unit 305B. The channel 380C is between the light source layers 320E and 320F and is below the microelectronic unit 305B. Each channel 380 has a height 387 along the Z axis. The height 387 may be approximately 3 mm.

The channels 380 can facilitate dissipation of heat from the microelectronic unit 305A and the microelectronic unit 305B. The heat may be generated by the IC device 340, 350, or 360. A channel 380 can also facilitate vertical optical communications within the microelectronic assembly 300, such as transmission of optical signals in directions along the Z axis. The channel 380 may be substantially transparent so that light can pass through. In some embodiments, the channel 380 may include one or more optical lenses that can converge or diverge the light. The transparency of channel 380 (plus optionally, appropriate lensing) can enable transmission of significant bandwidth over a small distance (e.g., a millimeter range) and still support thermal control between the microelectronic units 305A and 305B. An embodiment of each channel 380 may be the channel 280 in FIG. 2. In some embodiments, a light source layer 320 or an optical interconnect layer 330 can facilitate edge connected fiber cabling to support bandwidth between the microelectronic units 305A and 305B. The edge connected fiber cabling may also allow connectivity of the microelectronic assembly 300 with one or more other microelectronic assembly. Optical communication through the edge connected fiber cabling may supplement or even replace optical communication through a channel 380, e.g., at a larger system complexity and power efficiency cost due to needing external cabling.

The microelectronic assembly 300 has a heterogeneous stack in which the microelectronic unit 305A is arranged on top of the microelectronic unit 305B. Even though the heterogeneous stack includes the two microelectronic units 305A and 305B in FIG. 3, the heterogeneous stack may include one or more other microelectronic units in addition to the microelectronic units 305A and 305B. The one or more other microelectronic units may be arranged over the microelectronic unit 305A or the microelectronic unit 305B in a direction along the Z axis. The mechanical support provided by one or more of the pillars 310and the heat dissipation mechanism provided by the channels 380 can enable scalable heterogeneous integration. A large number of microelectronic units may be stacked in the microelectronic assembly 300 without causing overheating of the internal microelectronic units.

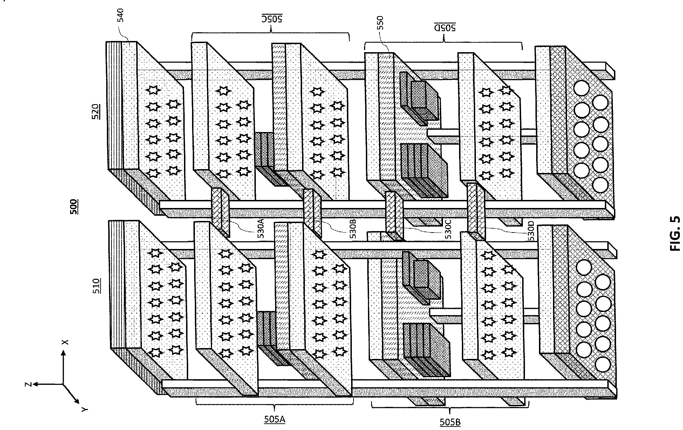

FIG. 3 shows vertical stacking of microelectronic units, i.e., stacking along the Z axis. In other embodiments, microelectronic units may be stacked horizontally (e.g., in the X-Y plane) to further promote the scalability of heterogeneous integration. More details about horizontal stacking are described below in conjunction with FIG. 5.

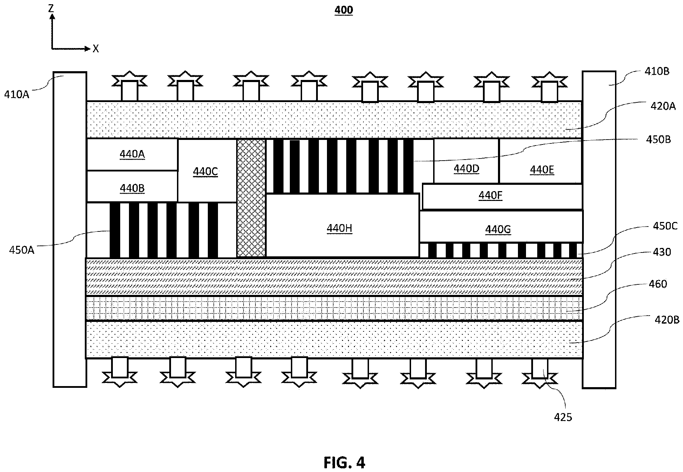

FIG. 4 is a cross-sectional view of an example microelectronic unit 400, according to some embodiments of the disclosure. The microelectronic unit 400 may be the microelectronic unit 100 in FIG. 1 or the microelectronic unit 305A or 305B in FIG. 3. The cross-section of the microelectronic unit 400 shown in FIG. 4 may be a cross-section in an X-Z plane. As shown in FIG. 4, the microelectronic unit 400 includes electrically conductive structures 410A and 410B (collectively referred to as "electrically conductive structures 410" or "electrically conductive structure 410"), light source structures 420A and 420B (collectively referred to as "light source structures 420" or "light source structure 420"), an optical interconnect structure 430, IC devices 440A-440H, interposers 450A-450C, and an intermediate layer 460. In other embodiments, the microelectronic unit 400 may include fewer, more, or different components. For instance, the microelectronic unit 400 may include a different number of electrically conductive structure(s) 410, a different number of light source structure(s) 420, multiple optical interconnect structures 430, a different number of IC device(s) 440, or a different number of interposer(s) 450. Also, the arrangement of one or more of the components of the microelectronic unit 400 may be different. For instance, the intermediate layer 460 may be below the light source layer 420B in other embodiments.

Each electrically conductive structure 410 can deliver power to one or more other components of the microelectronic unit 400. An electrically conductive structure 410 may also provide mechanical support to the microelectronic unit 400. Each electrically conductive structure 410 may be an embodiment of at least part of a pillar 110 in FIG. 1, pillar 210 in FIG. 2, or pillar 310 in FIG. 3.

Each light source structure 420 can emit light that can be used for optical communication, including horizontal optical communication (e.g., optical communications through the optical interconnect structure 430) and vertical optical communication (e.g., optical communications of the microelectronic unit 400 with one or more other microelectronic units stacked above or below the microelectronic unit 400). Each light source structure 420 includes light emitters 425. A light emitter 425 may be a micro-LED. Each light source structure 420 may be an embodiment of a light source layer 120 in FIG. 1, light source layer 220 in FIG. 2, or light source layer 320 in FIG. 3.

The optical interconnect structure 430 includes one or more optical interconnects that can be used to transmit optical signals. The optical interconnect structure 430 may also include a modular that can modulate light generated by a light source structure 420 to generate a modulated optical signal. The optical interconnect structure 430 may be an embodiment of the optical interconnect layer 130 in FIG. 1, the optical interconnect layer 230 in FIG. 2, or the optical interconnect layer 330 in FIG. 3.

The intermediate layer 460 is between the optical interconnect structure 430 and the light source layer 420B. The intermediate layer 460 may be bonded to the optical interconnect structure 430 or the light source layer 420B through WtW attachment. In some embodiments, the intermediate layer 460 is a single layer. In other embodiments, the intermediate layer 460 includes multiple layers bonded together, e.g., through WtW attachment. In an example, the intermediate layer 460 may include a power plane, such as a PMIC power plane. The power plane may provide power to the light source layer 420B. The intermediate layer 460 may be substantially transparent or include an optical medium that allows transmission of light through the intermediate layer 460.

The IC devices 440 may be components of a computer system, such as the computing device 2400 in FIG. 24. Examples of the IC devices 440 include processor, memory, register file tile, switch CMOS (complementary metal oxide semiconductor) device, FPGA (field programmable gate array), ASIC (application-specific IC) device, or other types of IC devices. An IC device 440 may receive an optical signal from the optical interconnect structure 430. The IC device 440 may also convert the optical signal to electrical signal. Each IC device 440 may be an example of (or an example of part of) the IC device 140 or 150 in FIG. 1, the IC device 240 or 250 in FIG. 2, or the IC device 340, 350, or 360 in FIG. 3. Examples of

The interposers 450 may facilitate connections and communications among the light source structure 420A, the optical interconnect structure 430, and some or all of the IC devices 440. Each interposer 450 may include a plurality of electrically conductive elements, such as wires, vias, etc. In some embodiments, the pitch of the electrically conductive elements in an interposer 450 may have a pitch of approximately 1 µm . An interposer 450 may be bonded to an IC device 440 through CtC attachment. An interposer 450 may be bonded to the light source structure 420A or the optical interconnect structure 430 through CtW attachment. In some embodiments, a light source structure 420 or the optical interconnect structure 430 can facilitate edge connected fiber cabling to allow connectivity between stacks or to support bandwidth between microelectronic units in the same stack.

FIG. 5 is a perspective view of an example microelectronic assembly 500 including microelectronic sub-assemblies 505A-505D stacked vertically and horizontally, according to some embodiments of the disclosure. The microelectronic assembly 500 may be a PIC package or part of a PIC package. The microelectronic assembly 500 includes two sections 510 and 520 that abuts each other along the X axis, i.e., horizontally stacked. For the purpose of simplicity and illustration, the horizontal stacking in FIG. 5 is along the X axis. In other embodiments, horizontal stacking of microelectronic sub-assemblies can be in other directions in the X-Y plane, such as direction along the Y axis. The section 510 includes the microelectronic sub-assemblies 505A and 505B which are vertically stacked along the Z axis. The section 520 includes the microelectronic sub-assemblies 505C and 505D which are vertically stacked along the Z axis. In some embodiments, the section 510 or 520 may be referred to as a socket. In other embodiments, the microelectronic assembly 500 may include a different number of microelectronic sub-assemblies or the microelectronic sub-assemblies 505A-505D (collectively referred to as "microelectronic sub-assemblies 505" or "microelectronic sub-assembly 505") may be stacked in a different manner. An embodiment of a microelectronic sub-assembly 505 may be the microelectronic unit 100 in FIG. 1 or the microelectronic unit 305A or 305B in FIG. 3.

In addition to the microelectronic sub-assemblies 505, the microelectronic assembly 500 includes coupling elements 530A-530D (collectively referred to as "coupling elements 530" or "coupling element 530"). The coupling elements 530 facilitates the stacking of the microelectronic sub-assemblies 505. For instance, the microelectronic sub-assembly 505A is affixed to the microelectronic sub-assembly 505C through the coupling elements 530A and 530B, and the microelectronic sub-assembly 505B is affixed to the microelectronic sub-assembly 505D through the coupling elements 530C and 530D. A coupling element 530 may be part of a microelectronic sub-assembly 505, and the other microelectronic sub-assembly 505 may be formed with an indentation (not shown in FIG. 5) that can receive the coupling element 530. With the coupling element 530 and the indentation, the two microelectronic sub-assemblies 505 can be attached to each other. In some embodiments, each of the two microelectronic sub-assemblies 505 may include one or more coupling elements and one or more indentations. For instance, the microelectronic sub-assembly 505A may include the coupling element 530A and an indentation to receive the coupling element 530B, and the microelectronic sub-assembly 505C may include the coupling element 530B and an indentation to receive the coupling element 530A.

As shown in FIG. 5, each coupling element 530 is associated with a light source layer 540 or an optical interconnect layer 550. The light source layer 540 may be an embodiment of a light source layer 120, 220, or 320. The optical interconnect layer 550 may be an embodiment of the optical interconnect layer 130, 230, or 330. The coupling element 530 may be affixed on a side surface of the light source layer 540 or optical interconnect layer 550. Alternatively, the coupling element 530 may be formed by removing one or more portions of the support structure of the light source layer 540 or an optical interconnect layer 550. A coupling element 530 may be on other sides of a light source layer 540 or an optical interconnect layer 550, which can facilitate stacking in another direction in the X-Y plane.

For the purpose of illustration, the coupling elements 530 are visible in FIG. 5. In other embodiments, a coupling element may be partially or wholly invisible after the attachment of two microelectronic sub-assemblies 505.Even though FIG. 5 shows two coupling elements 530 for each pair of microelectronic sub-assemblies 505, a pair of microelectronic sub-assemblies 505 may include a different number of coupling elements 530. Also, a coupling element 530 may have a different configuration (e.g., shape, size, location, material composition, etc.) from the configuration shown in FIG. 5. Further, the horizontal attachment of the microelectronic sub-assemblies 505 can be achieved through other coupling mechanisms.

In some embodiments, the coupling elements 530 may also facilitate communicative coupling between the microelectronic sub-assemblies 505. A coupling element 530 may include one or more optical interconnects (e.g., optical fibers, optical waveguides, etc.) that can facilitate optical communications between the microelectronic sub-assemblies 505. A coupling element 530 may include an optical medium, e.g., silicon. Optical signals can be transmitted between the horizontally stacked microelectronic sub-assemblies 505 through the coupling element 530.

In addition to the vertical stacking of the microelectronic sub-assemblies 505A and 505B and the vertical stacking of the microelectronic sub-assemblies 505C and 505D, the coupling elements 530 provides a modular attachment mechanism that allows the horizontal stacking of the microelectronic sub-assemblies 505A and 505C and the horizontal stacking of the microelectronic sub-assemblies 505B and 505D. One or more other microelectronic sub-assemblies can be stacked into the microelectronic assembly 500. Thus, a highly scalable heterogeneous integration can be achieved.

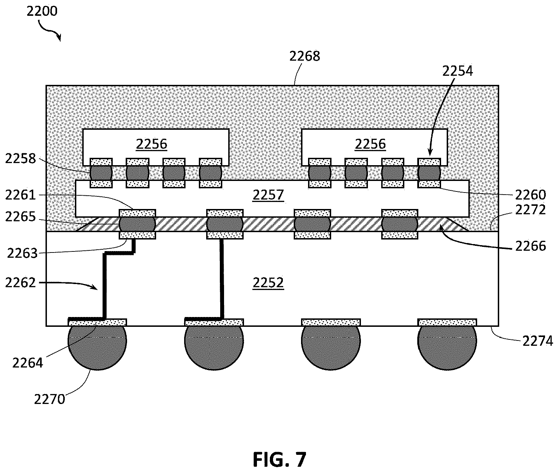

FIGS. 6A-6B are top views of a wafer 2000 and dies 2002, according to some embodiments of the disclosure. In some embodiments, the dies 2002 may be included in an IC package including one or more microelectronic assemblies capable of vertical and horizontal optical communications, according to some embodiments of the disclosure. For example, any of the dies 2002 may serve as any of the dies 2256 in an IC package 2200 shown in FIG. 7. The wafer 2000 may be composed of semiconductor material and may include one or more dies 2002 having IC devices formed on a surface of the wafer 2000. The wafer 2000 or a die 2002 may be part of a light source layer, optical interconnect layer, or IC device, such as the ones described above in conjunction with FIGS. 1-5.

Each of the dies 2002 may be a repeating unit of a semiconductor product that includes any suitable IC (e.g., ICs with performance enhanced by local layout effect as described herein). After the fabrication of the semiconductor product is complete, the wafer 2000 may undergo a singulation process in which each of the dies 2002 is separated from one another to provide discrete "chips" of the semiconductor product. In particular, devices performance enhanced by local layout effect as disclosed herein may take the form of the wafer 2000 (e.g., not singulated) or the form of the die 2002 (e.g., singulated). The die 2002 may include one or more diodes, one or more transistors as well as, optionally, supporting circuitry to route electrical signals to the III-N diodes with n-doped wells and capping layers and III-N transistors, as well as any other IC components. In some embodiments, the wafer 2000 or the die 2002 may implement an electrostatic discharge (ESD) protection device, a RF front-end device, a memory device (e.g., a static random-access memory (SRAM) device), a logic device (e.g., an AND, OR, NAND, or NOR gate), or any other suitable circuit element. Multiple ones of these devices may be combined on a single die 2002.

FIG. 7 is a side, cross-sectional view of an example IC package 2200 that may include one or more microelectronic assemblies capable of vertical and horizontal optical communications, according to some embodiments of the disclosure. In some embodiments, the IC package 2200 may be a system-in-package (SiP).

As shown in FIG. 7, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 7 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 7 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

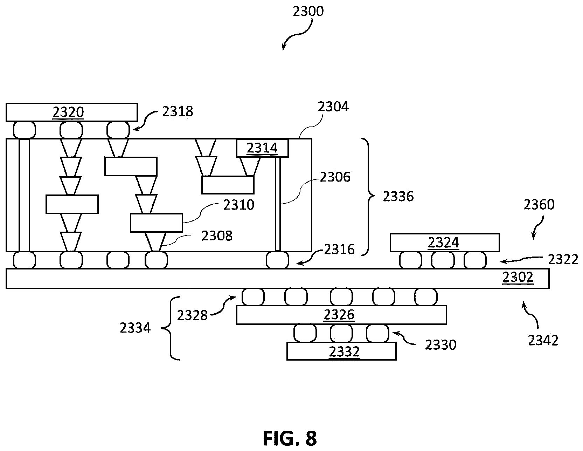

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 7 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 8.

The dies 2256 may take the form of any of the embodiments of the die 2002 discussed herein. In embodiments in which the IC package 2200 includes multiple dies 2256, the IC package 2200 may be referred to as a multi-chip package. Importantly, even in such embodiments of an multi-chip implementation of the IC package 2200, components of the IC package 2200 may be provided in a single chip, in accordance with any of the embodiments described herein. The dies 2256 may include circuitry to perform any desired functionality. For example, one or more of the dies 2256 may be ESD protection dies, one or more of the dies 2256 may be logic dies (e.g., silicon-based dies), one or more of the dies 2256 may be memory dies (e.g., high bandwidth memory), etc. In some embodiments, at least some of the dies 2256 may not include any III-N diodes with n-doped wells and capping layers.

The IC package 2200 illustrated in FIG. 7 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 7, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 8 is a cross-sectional side view of an IC device assembly 2300 that may include components having one or more microelectronic assemblies capable of vertical and horizontal optical communications, according to some embodiments of the disclosure. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the microelectronic assemblies capable of vertical and horizontal optical communications in accordance with any of the embodiments disclosed herein; e.g., any of the IC packages discussed below with reference to the IC device assembly 2300 may take the form of any of the embodiments of the IC package 2200 discussed above with reference to FIG. 7 (e.g., may include one or more microelectronic assemblies capable of vertical and horizontal optical communications).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 8 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 8), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 6B), an IC device (e.g., the IC device of FIGS. 1-2), or any other suitable component. In particular, the IC package 2320 may include one or more microelectronic assemblies capable of vertical and horizontal optical communications as described herein. Although a single IC package 2320 is shown in FIG. 8, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 8, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to TSVs 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 8 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

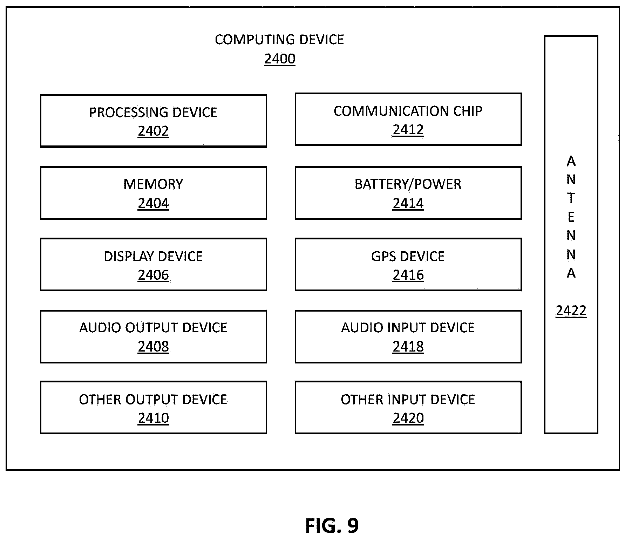

FIG. 9 is a block diagram of an example computing device 2400 that may include one or more components with one or more microelectronic assemblies capable of vertical and horizontal optical communications, according to some embodiments of the disclosure. For example, any suitable ones of the components of the computing device 2400 may include a die (e.g., the die 2002 of FIG. 6B) included in or associated with microelectronic assemblies capable of vertical and horizontal optical communications, according to some embodiments of the disclosure. Any of the components of the computing device 2400 may include a microelectronic assembly capable of vertical and horizontal optical communications (e.g., any embodiment of the microelectronic assemblies described above in conjunction with FIGS. 2, 3, and 5) and/or an IC package (e.g., the IC package 2200 of FIG. 7). Any of the components of the computing device 2400 may include an IC device assembly (e.g., the IC device assembly 2300 of FIG. 8).

A number of components are illustrated in FIG. 9 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC (system-on-chip) die.

Additionally, in various embodiments, the computing device 2400 may not include one or more of the components illustrated in FIG. 9, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, microelectronic assemblies capable of vertical and horizontal optical communications as described herein may include ESD circuits protecting power amplifiers, low-noise amplifiers, filters (including arrays of filters and filter banks), switches, or other active components. In some embodiments, microelectronic assemblies capable of vertical and horizontal optical communications as described herein may include PMICs. In some embodiments, microelectronic assemblies capable of vertical and horizontal optical communications as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include another output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include another input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides a microelectronic assembly, including a first layer including a first array of micro-LEDs; a second layer including a second array of micro-LEDs; a third layer between the first layer and the second layer, the third layer including an optical interconnect; and a pillar electrically coupled to the first layer and the second layer, where the first layer is substantially parallel to the second layer or the third layer, and the pillar extends in a direction substantially perpendicular to the first layer, the second layer, or the third layer.

Example 2 provides the microelectronic assembly according to example 1, further including a fourth layer including an array of micro-LEDs, where the fourth layer is closer to the second layer than the first layer, and a channel is between the second layer and the fourth layer.

Example 3 provides the microelectronic assembly according to example 2, where a dimension of the channel along the direction perpendicular to the first layer, the second layer, or the third layer is approximately three millimeters.

Example 4 provides the microelectronic assembly according to example 2 or 3, where the channel is at least partially filled with a fluid.

Example 5 provides the microelectronic assembly according to any of the preceding examples, where the second layer has a first surface and a second surface opposing the first surface, the first layer is closer to the first surface than the second surface, and the second array of micro-LEDs are on the second surface.

Example 6 provides the microelectronic assembly according to any of the preceding examples, further including one or more semiconductor devices between the second layer and the third layer, where the one or more semiconductor devices are electrically coupled to the third layer.

Example 7 provides the microelectronic assembly according to example 6, where the one or more semiconductor devices are attached on the third layer.

Example 8 provides a microelectronic assembly, including a first sub-assembly, the first sub-assembly including a first array of micro-LEDs, a second array of micro-LEDs, and a first optical interconnect plane between the first array of micro-LEDs and the second array of micro-LEDs; a second sub-assembly over the first sub-assembly in a direction, the second sub-assembly including a third array of micro-LEDs, a fourth array of micro-LEDs, and a second optical interconnect plane between the third array of micro-LEDs and the fourth array of micro-LEDs; and a structure crossing the first sub-assembly and the second sub-assembly in the direction.

Example 9 provides the microelectronic assembly according to example 8, further including a third sub-assembly abutting the first sub-assembly, the third sub-assembly including a fifth array of micro-LEDs, a six array of micro-LEDs, and a third optical interconnect plane between the fifth array of micro-LEDs and the six array of micro-LEDs, where the first sub-assembly and the third sub-assembly are in a first section of the microelectronic assembly, the second sub-assembly is in a second section of the microelectronic assembly, and the second section is over the first section in the direction.

Example 10 provides the microelectronic assembly according to example 9, where the first sub-assembly further includes an optical element, and the optical element contacts the third sub-assembly.

Example 11 provides the microelectronic assembly according to any one of examples 8-10, further including a layer including a fifth array of micro-LEDs, where the second sub-assembly is between the first sub-assembly and the layer in the direction.

Example 12 provides the microelectronic assembly according to any one of examples 8-11, where a channel is between the first sub-assembly and the second sub-assembly, and the channel is partially filled with a fluid.

Example 13 provides the microelectronic assembly according to example 12, where a dimension of the channel along the direction is approximately three millimeters.

Example 14 provides the microelectronic assembly according to any one of examples 8-13, where the structure is electrically coupled to the first array of micro-LEDs, the second array of micro-LEDs, the third array of micro-LEDs, or the fourth array of micro-LEDs.

Example 15 provides a microelectronic assembly device, including a first light source structure including a first group of light emitters; a second light source structure including a second group of light emitters; a third light source structure including a third group of light emitters; an optical interconnect structure including an optical interconnect; and an electrically conductive structure extending in a direction that is substantially perpendicular to the first light source structure, the second light source structure, or the optical interconnect structure, where the second light source structure is between the first light source structure and the third light source structure, and the optical interconnect structure is between the first light source structure and the second light source structure.

Example 16 provides the microelectronic assembly according to example 15, where an individual light emitter is associated with an optical lens.

Example 17 provides the microelectronic assembly according to example 15 or 16, where an individual light emitter is a micro-LED.

Example 18 provides the microelectronic assembly according to any one of examples 15-17, where the second light source structure is communicatively coupled to the third light source structure.

Example 19 provides the microelectronic assembly according to example 18, where the second group of light emitters is attached on a surface of the second light source structure, the third group of light emitters is attached on a surface of the third light source structure, and the surface of the second light source structure faces the surface of the third light source structure.

Example 20 provides the microelectronic assembly according to any one of examples 15-19, where a distance from the second light source structure to the third light source structure in the direction is approximately three millimeters.

Example 21 provides an IC package, including the microelectronic assembly according to any one of examples 1-20; and a further IC component, coupled to the device.

Example 22 provides the IC package according to example 21, where the further IC component includes one of a package substrate, an interposer, or a further IC die.

Example 23 provides the IC package according to example 21 or 22, where the microelectronic assembly according to any one of examples 1-20 may include, or be a part of, at least one of a memory device, a computing device, a wearable device, a handheld electronic device, and a wireless communications device.

Example 24 provides an electronic device, including a carrier substrate; and one or more of the microelectronic assemblies according to any one of examples 1-20 and the IC package according to any one of examples 21-23, coupled to the carrier substrate.

Example 25 provides the electronic device according to example 24, where the carrier substrate is a motherboard.

Example 26 provides the electronic device according to example 24, where the carrier substrate is a PCB.

Example 27 provides the electronic device according to any one of examples 24-26, where the electronic device is a wearable electronic device or handheld electronic device.

Example 28 provides the electronic device according to any one of examples 24-27, where the electronic device further includes one or more communication chips and an antenna.

Example 29 provides the electronic device according to any one of examples 24-28, where the electronic device is an RF transceiver.

Example 30 provides the electronic device according to any one of examples 24-28, where the electronic device is one of a switch, a power amplifier, a low-noise amplifier, a filter, a filter bank, a duplexer, an upconverter, or a downconverter of an RF communications device, e.g., of an RF transceiver.

Example 31 provides the electronic device according to any one of examples 24-30, where the electronic device is a computing device.

Example 32 provides the electronic device according to any one of examples 24-31, where the electronic device is included in a base station of a wireless communication system.

Example 33 provides the electronic device according to any one of examples 24-31, where the electronic device is included in a user equipment device of a wireless communication system.

Example 34 provides processes for forming the microelectronic assembly according to any one of claims 1-20.

Example 35 provides processes for forming the IC package according to any one of the claims 21-23.

Example 36 provides processes for forming the electronic device according to any one of the claims 24-33.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
a first layer comprising a first array of micro light-emitting diodes (micro-LEDs);
a second layer comprising a second array of micro-LEDs;
a third layer between the first layer and the second layer, the third layer comprising an optical interconnect; and
a pillar electrically coupled to the first layer and the second layer,
wherein the first layer is substantially parallel to the second layer or the third layer, and the pillar extends in a direction substantially perpendicular to the first layer, the second layer, or the third layer.

2. The microelectronic assembly according to claim 1, further comprising:
a fourth layer comprising an array of micro-LEDs,
wherein the fourth layer is closer to the second layer than the first layer, and a channel is between the second layer and the fourth layer.

3. The microelectronic assembly according to claim 2, wherein:
a dimension of the channel along the direction perpendicular to the first layer, the second layer, or the third layer is approximately three millimeters; or
the channel is at least partially filled with a fluid.

4. The microelectronic assembly according to any one of claims 1-3, wherein:
the second layer has a first surface and a second surface opposing the first surface,
the first layer is closer to the first surface than the second surface, and
the second array of micro-LEDs are on the second surface.

5. The microelectronic assembly according to any one of claims 1-4, further comprising:
one or more semiconductor devices between the second layer and the third layer, wherein the one or more semiconductor devices are electrically coupled to the third layer,
wherein the one or more semiconductor devices are attached on the third layer.

6. A microelectronic assembly, comprising:
a first sub-assembly, the first sub-assembly comprising a first array of micro light-emitting diodes (micro-LEDs), a second array of micro-LEDs, and a first optical interconnect plane between the first array of micro-LEDs and the second array of micro-LEDs;
a second sub-assembly over the first sub-assembly in a direction, the second sub-assembly comprising a third array of micro-LEDs, a fourth array of micro-LEDs, and a second optical interconnect plane between the third array of micro-LEDs and the fourth array of micro-LEDs; and
a structure crossing the first sub-assembly and the second sub-assembly in the direction.

7. The microelectronic assembly according to claim 6, further comprising:
a third sub-assembly abutting the first sub-assembly, the third sub-assembly comprising a fifth array of micro-LEDs, a six array of micro-LEDs, and a third optical interconnect plane between the fifth array of micro-LEDs and the six array of micro-LEDs,
wherein the first sub-assembly and the third sub-assembly are in a first section of the microelectronic assembly, the second sub-assembly is in a second section of the microelectronic assembly, and the second section is over the first section in the direction.

8. The microelectronic assembly according to claim 7, wherein the first sub-assembly further comprises an optical element, and the optical element contacts the third sub-assembly.

9. The microelectronic assembly according to any one of claims 6-8, further comprising:
a layer comprising a fifth array of micro-LEDs, wherein the second sub-assembly is between the first sub-assembly and the layer in the direction.

10. The microelectronic assembly according to any one of claims 6-9, wherein a channel is between the first sub-assembly and the second sub-assembly, and the channel is partially filled with a fluid, and a dimension of the channel along the direction is approximately three millimeters.

11. The microelectronic assembly according to any one of claims 6-10, wherein the structure is electrically coupled to the first array of micro-LEDs, the second array of micro-LEDs, the third array of micro-LEDs, or the fourth array of micro-LEDs.

12. A microelectronic assembly, comprising:
a first light source structure comprising a first group of light emitters;
a second light source structure comprising a second group of light emitters;
a third light source structure comprising a third group of light emitters;
an optical interconnect structure comprising an optical interconnect; and
an electrically conductive structure extending in a direction that is substantially perpendicular to the first light source structure, the second light source structure, or the optical interconnect structure,
wherein the second light source structure is between the first light source structure and the third light source structure, and the optical interconnect structure is between the first light source structure and the second light source structure.

13. The microelectronic assembly according to claim 12, wherein:
an individual light emitter is associated with an optical lens; or
an individual light emitter is a micro-LED (light-emitting diode); or
the second light source structure is communicatively coupled to the third light source structure.

14. The microelectronic assembly according to claim 13, wherein:
the second group of light emitters is attached on a surface of the second light source structure,
the third group of light emitters is attached on a surface of the third light source structure, and
the surface of the second light source structure faces the surface of the third light source structure.

15. The microelectronic assembly according to any one of claims 12-14, wherein a distance from the second light source structure to the third light source structure in the direction is approximately three millimeters.
